# DEMANDE DE BREVET EUROPEEN

(11) **EP 0 619 644 A1**
(43) Date de publication de la demande: **12.10.1994**
(21) Numéro de dépôt: 94400542.0
(22) Date de dépôt: 14.03.1994
(51) Int. Cl.: H03B 5/12, H03B 5/36

(54) **Oscillateur sinusoidal à faible taux d'harmoniques et émetteur de télécommande utilisant un tel oscillateur**

(30) Priorité: 05.04.1993 FR 9303989
(71) Demandeur: VALEO ELECTRONIQUE, 94042 Creteil Cédex (FR)
(72) Inventeur: Rydel, Charles, F-75019 Paris (FR)
(74) Mandataire: Gamonal, Didier

(57) **Abrégé**

La présente invention concerne un oscillateur à faible taux d'harmoniques. Elle trouve application notamment pour un émetteur de signaux de télécommande.

L'oscillateur harmonique comporte un circuit résonnant (3) dont on utilise un élément inductif pour constituer un filtre passe- bas (6) qui coupe les fréquences supérieures au premier harmonique.

Application aux émetteurs de télécommande.

## Description

La présente invention concerne un oscillateur à faible taux d'harmoniques. Elle trouve application notamment dans un émetteur de signaux de télécommande.

Dans l'état de la technique, on a déjà proposé des montages permettant de produire des ondes sinusoïdales sous le nom d'oscillateurs harmoniques.

De tels oscillateurs sont déjà connus comme produisant un faible taux d'harmoniques, et en ce qu'ils produisent, à leur fréquence de fonctionnement stable, un signal réputé contenir moins d'harmoniques que les oscillateurs d'autres types comme les oscillateurs en relaxation.

Cependant, on sait que les oscillateurs harmoniques produisent un certain taux d'harmoniques en particulier lorsqu'ils passent du régime de démarrage au régime permanent, mais aussi en régime permanent.

Dans l'état de la technique, on a déjà proposé de symétriser les montages oscillateurs, la symétrisation du montage par rapport à un potentiel de référence, comme dans un montage de type push pull, permettant d'éliminer les harmoniques d'ordre pair et de renforcer l'harmonique à la fréquence de travail.

Cependant, l'encombrement du spectre fréquentiel en particulier dans le spectre des radiofréquences est devenu tel que les normes exigent des affaiblissements au delà de la fréquence de travail, en harmonique 1, donc d'ordre impair, toujours plus importants.

En particulier, la présente invention est destinée à un émetteur de signaux de télécommande comme un émetteur de télécommande fonctionnant dans les radiofréquences, qui comporte un moyen produisant un mot de code constitué d'une pluralité de signaux en forme de créneaux. Chaque créneau dure un temps prédéterminé pendant lequel un oscillateur harmonique est activé.

Pendant la durée d'activation, l'oscillateur doit monter à sa fréquence de fonctionnement stable aussi rapidement que possible, et s'y maintenir sans générer d'harmoniques élevées de façon à ne pas polluer l'environnement électromagnétique.

Dans cette disposition, on voit que la génération d'harmoniques élevées est encore plus forte que pour des montages fonctionnant en permanence, en particulier parce que la durée des créneaux peut être aussi brève que 10 microsecondes. De ce fait, on produit une modulation de fréquences qui peut se prolonger dans le spectre.

Une solution consiste à faire suivre l'oscillateur harmonique, symétrisé ou non, par un filtre passe-bas qui affaiblit considérablement les harmoniques à partir de 2.Ft, si Ft est la fréquence de travail de l'oscillateur harmonique, c'est-à-dire le premier harmonique.

Mais cette solution conduit à une augmentation des moyens, donc à de nombreux inconvénients qui s'en suivent comme :
- l'augmentation de la complexité du circuit, qui rend son intégration plus difficile ;
- l'augmentation des possibilités de divergences au vieillissement ou aux agressions comme la température;
- l'augmentation de la susceptibilité électromagnétique ;
- l'augmentation du coût.

L'invention propose une solution qui apporte remède à ces divers inconvénients sans utiliser beaucoup de moyens supplémentaires.

En effet, la présente invention concerne un oscillateur harmonique qui comporte principalement :
- un étage amplificateur ;
- un réservoir d'énergie résonnant comme un circuit accordé ;
- une boucle de rétroaction qui renvoie une fraction prédéterminée de l'énergie stockée à l'entrée de l'amplificateur.

L'invention se caractérise en ce qu'une partie du circuit accordé constitue un filtre passe-bas dont la sortie constitue la sortie de l'oscillateur.

L'invention concerne aussi un émetteur de télécommande, destiné notamment à faire fonctionner à distance un appareil doté d'un récepteur convenable, en particulier de type radiofréquence, mais non nécessairement.

Un tel émetteur est plus particulièrement adapté à la télécommande de verrouillage/déverrouillage des ouvrants et/ou d'organes de blocage de système antivol et/ou d'un alarme de véhicule.

L'émetteur de télécommande se caractérise en ce qu'il comporte un générateur de signal de modulation dont la sortie est connectée à l'entrée de l'amplificateur d'un oscillateur harmonique, dont la sortie est couplée à un organe rayonnant comme une antenne radiofréquence.

L'invention se caractérise en ce que l'émetteur comporte un filtre passe-bas qui fait partie de l'oscillateur harmonique.

Selon un mode de réalisation, l'oscillateur harmonique est de type Hartley.

Selon un autre mode de réalisation, l'oscillateur harmonique est de type Colpits.

Selon un autre mode de réalisation, la boucle de rétroaction est connectée entre la sortie du circuit résonnant et la base d'un transistor d'entrée de l'amplificateur.

Selon un autre mode de réalisation, la boucle de rétroaction est connectée entre la sortie du circuit résonnant et l'émetteur d'un transistor de l'amplificateur.

Dans un mode de réalisation, le montage est destiné à exciter une source de rayonnement radiofréquence, ou un signal électrique transmis sur une ligne filaire ou autrement.

D'autres caractéristiques et avantages de la présente invention seront mieux compris à l'aide de la description et des dessins qui sont :
- la figure 1 : un schéma de principe d'un oscillateur harmonique selon l'état de la technique ;
- la figure 2 : un schéma de principe d'un oscillateur harmonique selon la présente invention ;
- la figure 3 : un schéma électrique d'un émetteur de télécommande équipé d'un oscillateur de type Colpits dans lequel on a implémenté l'invention ;
- la figure 4 : un schéma d'une variante d'une partie du circuit de la figure 3.

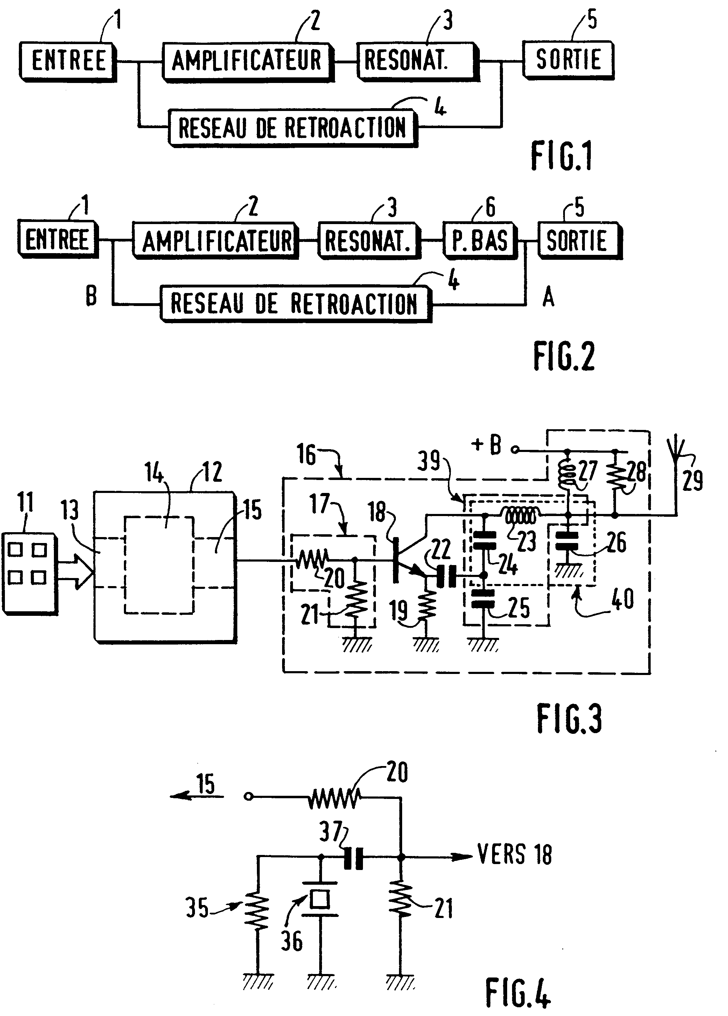

A la figure 1, on a représenté le schéma de principe d'un oscillateur harmonique. Un tel oscillateur comporte un étage d'entrée 1 connecté à l'entrée d'un amplificateur 2 qui sert à regénérer l'énergie consommée par l'oscillateur lui-même en prélevant de l'énergie sur une source d'énergie non représenté.

La sortie de l'amplificateur 2 est connectée à l'entrée d'un circuit résonnant 3, par exemple constitué à partir d'une inductance et de condensateurs, qui sert de réservoir d'énergie. Le circuit résonnant peut prendre des formes variées comme les structures Colpits ou Hartley, ou d'autres encore bien connues. Un tel résonateur comporte des réactances qui permettent de stocker de l'énergie réactive.

La sortie du résonateur 3 est connectée à un dispositif de sortie 5 et à l'entrée d'une boucle de rétroaction qui prélève une partie de l'énergie résonnante sur le circuit résonnant 3 et le renvoie dans le réseau d'entrée de l'amplificateur.

A la Figure 2, on a représenté un oscillateur harmonique équipé du moyen de l'invention. Le circuit résonnant comporte lui-même des éléments inductifs et capacitifs qui permettent de constituer un filtre passe-bas qui sert à produire non pas une sortie d'oscillateur filtrée par un dispositif supplémentaire, comme c'est le cas si on applique l'enseignement de l'art antérieur, mais à filtrer directement la sortie du circuit résonnant en l'empêchant de résonner, ou à tout le moins en limitant sa puissance de résonance dans les hautes fréquences.

Le réseau de rétroaction 4 qui est connecté à la sortie du filtre passe-bas permet de multiplier les effets du filtrage et de ce fait, améliore la pureté du spectre de sortie de l'oscillateur.

A la Figure 3, on a représenté un circuit représentant un émetteur de télécommande mettant en oeuvre un oscillateur harmonique modifié selon le concept de l'invention.

L'émetteur comporte un microcontrôleur 12 dont un port d'entrée 13 décode un clavier de télécommande 11. Quand l'utilisateur produit un enfoncement d'une touche, ou d'une séquence de touches du clavier, ou quand l'utilisateur produit une commande prédéterminée, le port d'entrée 13 est placé dans un état déterminé qui est décodé par un programme implanté 14 dans le microcontrôleur 12.

Le programme 14 exécute ensuite une routine de codage d'un signal de télécommande sous la forme d'une série de créneaux de tensions entre 0 et 3 Volts par exemple, de durées prédéterminées. Chaque créneau est produit par un port de sortie 15 du microcontrôleur 12, qui sert d'étage d'entrée d'un oscillateur harmonique 16 selon l'invention.

L'oscillateur 16 comporte un étage d'entrée 17, qui, dans un mode de réalisation, comporte une première résistance 20 connectée entre l'entrée de l'oscillateur et l'entrée de l'amplificateur 18, et une seconde résistance 21 connectée entre l'entrée de l'amplificateur 18 et la masse électrique du montage.

Dans une variante, représentée à la figure 4, on ajoute au réseau d'entrée 17, un dispositif de contrôle comportant un cristal résonnant 36, comme un filtre résonateur à ondes acoustique de surface, éventuellement par l'intermédiaire d'une liaison capacitive, constitué par un condensateur 37. Ce type de montage permet d'asservir l'oscillateur harmonique sur une fréquence de résonance stable produite par le cristal.

En revenant à la figure 3, on a représenté ensuite l'amplificateur de l'oscillateur harmonique 17, qui est ici constitué par un transistor NPN 18 dont la base est connectée à la sortie du réseau d'entrée 17, et dont l'émetteur est connecté à la masse électrique par l'intermédiaire d'une résistance 19. D'autre part, la sortie de l'amplificateur est constituée par le collecteur du transistor 18 et est connecté à l'entrée du circuit servant de réservoir d'énergie constitué par un circuit résonnant qui comporte une première branche constituée de deux condensateurs en série 24, 25, et d'une seconde branche constituée d'une inductance 23.

Selon l'invention, le circuit résonnant, représenté entouré d'un tiret 39, est complété par un condensateur 26 connecté entre une extrémité de l'inductance 23 et la masse. Ainsi connecté, ce condensateur 26 constitue avec l'inductance 23 et le condensateur 24, un filtre passe-bas en "PI", représenté entouré d'une ligne de points 40.

La sortie 27 - 28 de l'oscillateur est connectée sur la polarité +B d'une source d'alimentation continue comme un accumulateur ou une pile, par l'intermédiaire d'une résistance 28. L'étage de sortie comporte d'autre part une antenne de rayonnement radiofréquence accordée 29 qui émet le rayonnement filtré produit par l'oscillateur.

La boucle de rétroaction est ici constituée par une liaison capacitive, comportant un simple condensateur 22, connectée au point commun entre les deux condensateurs 24 et 25 d'une part, et au point commun entre l'émetteur du transistor 18 et sa résistance d'émetteur 19. La boucle de rétroaction de l'oscillateur harmonique est ici assurée grâce à la jonction base-émetteur du transistor 18, ce qui nécessite que la connexion entre le circuit résonnant 23 - 26 et l'émetteur soit assurée par un condensateur 22.

Dans d'autres modes de réalisation, la boucle de rétroaction est fermée sur la base du transistor 18 par l'intermédiaire d'un condensateur de liaison.

Dans un mode de réalisation représenté au dessin, l'alimentation du montage est assurée par un dispositif 5 de sortie, représenté à la figure 3 à travers une inductance de liaison 27. Cette inductance est montée en parallèle avec une résistance 28 de façon à réduire le coefficient de surtension Q du filtre associé pour qu'il ne résonne pas avec l'inductance de choc 27.

A la Figure 3, on a représenté un oscillateur harmonique constitué sur un oscillateur de type Colpits. Il est possible d'utiliser d'autres structures résonnants, en particulier en composant la structure Colpits avec un oscillateur à cristal comme selon la figure 4, ou encore en utilisant un pont de réactances, une structure Hartley ou un réseau à retard de phase.

Dans ce cas, on dimensionne l'un des éléments du circuit résonnant de façon à constituer un filtre passe-bas dont la fréquence de coupure est comprise entre l'harmonique 1 et l'harmonique 2.

Il est clair que l'émetteur de télécommande peut être utilisé comme transmetteur de signaux sinusoïdaux sur un canal quelconque comme :
- une liaison hertzienne, ainsi qu'il est décrit à la figure 3 ;
- une liaison filaire, sur câble blindé, sur câble coaxial, sur paires torsadées, etc, pour les applications précitées.

## Revendications

1. Oscillateur harmonique, du type comportant :
- un étage amplificateur (2) ;
- un réservoir d'énergie résonnant comme un circuit accordé (3) ;
- une boucle de rétroaction (4) qui renvoie une fraction prédéterminée de l'énergie stockée à l'entrée de l'amplificateur (2), caractérisé en ce qu'une partie du circuit accordé (3) constitue un filtre passe-bas (6) dont la sortie constitue la sortie (5) de l'oscillateur.

2. Oscillateur harmonique selon la revendication 1, caractérisé en ce qu'il est de type Hartley, le filtre passe-bas étant constitué par un premier condensateur du résonateur, l'inductance du résonateur et un condensateur de filtrage.

3. Oscillateur harmonique selon la revendication 1, caractérisé en ce qu'il est de type Colpits, le filtre passe-bas étant un filtre en "PI", constitué par un premier condensateur (24) du résonateur, l'inductance (23) du résonateur et un condensateur de filtrage (26), connecté à la masse électrique.

4. Oscillateur harmonique selon les revendications 2 ou 3, caractérisé en ce que la boucle de rétroaction est connectée entre la sortie du circuit résonnant et la base d'un transistor d'entrée de l'amplificateur.

5. Oscillateur harmonique selon les revendications 2 ou 3, caractérisé en ce que la boucle de rétroaction est connectée entre la sortie du circuit résonnant et l'émetteur d'un transistor de l'amplificateur.

6. Oscillateur harmonique selon la revendication 1, caractérisé en ce que le circuit résonnant (3) est alimenté par l'intermédiaire d'une inductance de choc (27).

7. Oscillateur harmonique selon la revendication 6, caractérisé en ce que l'inductance de choc (27) est connectée dans un dispositif (5) permettant de réduire le gain de l'oscillateur de façon à ce qu'il ne résonne pas sur l'inductance de choc (27), dispositif (5) pouvant être constitué par une résistance (28) connectée en parallèle sur l'inductance de choc (27).

8. Emetteur de télécommande, destiné notamment à faire fonctionner à distance un appareil doté d'un récepteur convenable, en particulier de type radiofréquence, caractérisé en ce qu'il comporte un générateur de signal de modulation (11 - 15) dont la sortie (15) est connectée à l'entrée (17) de l'amplificateur (18) d'un oscillateur harmonique (16), dont la sortie (27, 28) est couplée à un organe rayonnant comme une antenne radiofréquence (29), caractérisé en ce que l'oscillateur harmonique est constitué selon l'une des revendications précédentes.
